# EUROPEAN PATENT APPLICATION

(11) **EP 4 769 945 A1**
(43) Date of publication of application: **01.07.2026**
(21) Application number: 25225706.8
(22) Date of filing: 19.12.2025
(51) Int. Cl.: H03K 5/01, H03K 5/12, H03K 19/017

(54) **CLOCK PATH ARCHITECTURE FOR HIGH-SPEED SYNCHRONOUS CIRCUITS**

(30) Priority: 31.12.2024 US 202419006517
(71) Applicant: Avago Technologies International Sales Pte. Limited, Singapore 768923 (SG)
(72) Inventor: Zhang, Heng, Irvine, 92620 (US); Cui, Delong, Tustin, 92782 (US); Cao, Jun, Irvine, 92620 (US)
(74) Representative: Dilg, Haeusler, Schindelmann Patentanwaltsgesellschaft mbH

(57) **Abstract**

An apparatus including a comparator and a plurality of replica current sources. The comparator outputs a control voltage onto an output line upon comparing a midpoint voltage with a feedback voltage. The control voltage indicates whether the feedback voltage is higher or lower than the midpoint voltage. Each of the replica current sources draws a supply voltage from a supply line. A replica current source enters into an inactive state in response to an enable signal being in a deactivating state. Upon entering the inactive state, the replica current source ceases drawing the control voltage from the output line.

## Description

### BACKGROUND

Synchronous circuits are a class of digital circuits in which a common clock signal synchronizes the flow of data throughout the circuits. The clock signal establishes the timing.

### BRIEF DESCRIPTION OF DRAWINGS

The accompanying drawings, which are incorporated in and form a part of this specification, illustrate examples of the disclosure and, together with the description, explain principles of the examples.
FIG. 1 illustrates an exemplary device, in accordance with one or more embodiments of the disclosure.
FIG. 2 illustrates an exemplary clock alignment circuit, in accordance with one or more embodiments of the disclosure.
FIG. 3 illustrates an exemplary current source, in accordance with one or more embodiments of the disclosure.
FIG. 4 illustrates an exemplary current sink, in accordance with one or more embodiments of the disclosure.
FIG. 5 illustrates exemplary configurations for resistance circuits, in accordance with one or more embodiments of the disclosure.
FIG. 6 illustrates an exemplary buffer current source, clock buffer and buffer current sink, in accordance with one or more embodiments of the disclosure.
FIG. 7 illustrates exemplary phase control circuitry, in accordance with one or more embodiments of the disclosure.
FIG. 8 illustrates an exemplary clock rise and fall times, in accordance with one or more embodiments of the disclosure.
FIG. 9 illustrates an exemplary laboratory measurements, in accordance with one or more embodiments of the disclosure.
FIG. 10 illustrates an exemplary settings, in accordance with one or more embodiments of the disclosure.

In the drawings, like reference symbols and numerals indicate the same or similar components. Like elements in the various figures are denoted by like reference symbols and numerals for consistency. Unless otherwise indicated, like elements and method steps are referred to with like reference numerals.

### DETAILED DESCRIPTION OF THE INVENTION

The following describes technical solutions in this specification with reference to the accompanying drawings. Exemplary embodiments are described in detail with reference to the accompanying drawings.

Clock mismatch and clock skew are dominant factors that can limit the performance of high-speed synchronous circuits.

Clock mismatch generally refers to discrepancies in timing between multiple clock signals within a system, which can significantly affect the accuracy and performance of a high-speed synchronous circuit where precise timing is critical. Clock mismatch can manifest as either a static mismatch or dynamic mismatch. Static mismatch can arise from factors such as non-ideal clock generation circuits, uneven routing, and random variations. Dynamic mismatch can arise from voltage and temperature variations.

Clock skew generally refers to the difference in the arrival times of a single clock signal at different components in a high-speed synchronous circuit. Causes of clock skew can include variations in clock distribution paths, such as unequal trace lengths, differing loads, or propagation delays. Clock skew can lead to timing violations, impacting the reliability and performance of the circuit.

Clock mismatch and/or clock skew can arise due to differences in clock frequency, propagation delays, phase alignment, or jitter. The aging effect can also be the cause of a clock mismatch and/or clock skew in a high-speed synchronous circuit. The aging effect refers to the gradual change in the performance or characteristics of a material, component, or system over time due to environmental conditions, usage, or inherent physical and chemical changes.

Clock mismatch and/or clock skew can generate spurs in the spectrum of a clock signal. Spurs, which are unwanted frequency components or signals that appear alongside the desired signal in the frequency domain, can degrade the accuracy and performance of a high-speed synchronous circuit as indicated by spurious free dynamic range (SFDR), signal to noise and distortion ratio (SNDR) and the effective number of bits (ENOB). Accordingly, there is a need in the art for an improved clock alignment circuit.

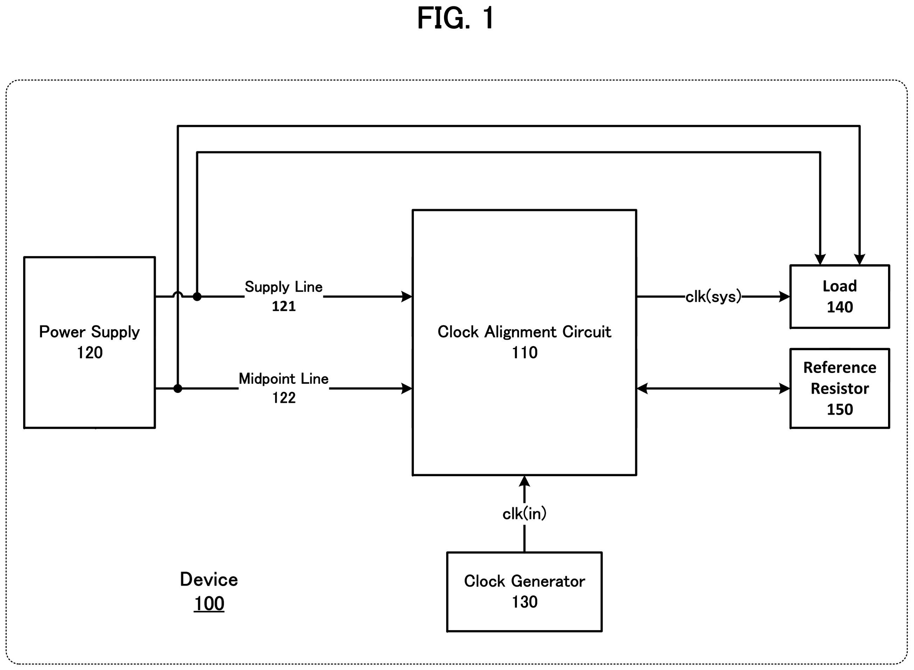

FIG. 1 illustrates an example device 100. Device 100 may be configured as any type of electrically powered device. For example, device 100 may be configured as a mobile communication device including, but not limited to, a mobile phone, a smart phone, cell phone, or tablet. Device 100 may be configured as a wearable device, a smartwatch, a fitness tracker or a personal digital assistant (PDA). In other examples, device 100 may be configured as a media device (e.g., media playing and/or recording device). For instance, device 100 may include portable music player, an audio device such as an audio recorder, an audio converter, an audio player, or a speaker (e.g., a Bluetooth-enabled speaker). In other instances, device 100 may include a video device such as a video display, a video recorder, a camera, or other video device. In another example, device 100 may be configured as, a driver assistance module in a vehicle, an emergency transponder, a pager, a watch, a satellite television receiver, a stereo receiver, a computer system, music player, laptop or tablet computer, home appliance, or virtually any other device. In another example, device 100 may be configured as a computer (e.g., a laptop computer). In other examples, device 100 may be configured as a computing/entertainment device for a vehicle.

Device 100 may include clock alignment circuit 110, power supply 120, clock generator 130, load 140 and reference resistor 150. Those skilled in the art will appreciate there may be additional components in device 100.

Power supply 120 is hardware that may condition and transform electric power into stable and precise supply and midpoint voltages. The voltage level of the midpoint voltage (Vdd/2) may be less than voltage level of a supply voltage (Vdd). In some instances, the voltage level of the midpoint voltage (Vdd/2) may be about half the voltage level of the supply voltage (Vdd). Power supply 120 may output the supply voltage (Vdd) on the supply voltage line 121 and may output the midpoint voltage (Vdd/2) on the midpoint voltage line 122.

Clock generator 130 may exist as a component that is responsible for generating a stable and precise input clock clk(in). Referred to herein, the input clock clk(in) may be any periodic waveform. A periodic waveform is a signal that repeats itself at regular intervals over time. Specifically, each cycle of the periodic waveform is a complete repetition of the signal that takes the same amount of time. Those skilled in the art will appreciate that the input clock clk(in) may exist in the form of a square wave, a rectangular wave, a sine wave, a triangle wave, a sawtooth wave and/or any other periodic waveform.

Load 140 is any component or group of components that may consume the supply and midpoint voltages. For example, load 140 may be an electronic circuit and/or an electronic device. Performance characteristics for load 140 may encompass parameters such as the resistance, impedance, and/or power requirements of load 140.

Reference resistor 150 is a high-precision, stable resistor. Reference resistor 150 may exist as a benchmark resistance. For instance, reference resistor 150 may exhibit an extraordinarily precise resistance value with minimal deviation across a wide temperature range. Reference resistor 150 may also exhibit excellent long-term stability with minimal drift over time.

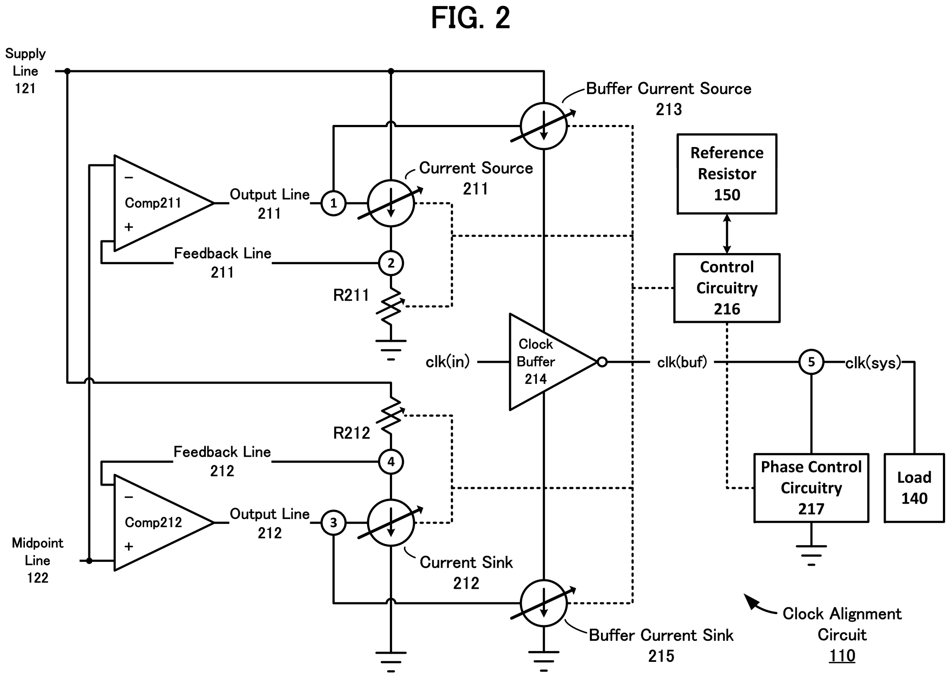

Turning now to FIG. 2, an example clock alignment circuit 110 is illustrated. Clock alignment circuit 110 is an apparatus that may include comparators comp211 and comp212, current sources 211, 213, resistance circuits R211, R212, current sinks 212, 215, clock buffer 214, control circuitry 216 and phase control circuitry 217. Wiring nodes 1-5 are also illustrated. Each of the wiring nodes 1-5 may be implemented as a conductive region of clock alignment circuit 110 and/or as conductive layers in clock alignment circuit 110. For instance, each of the wiring nodes 1-5 may include one or more wires or conductive traces that link together various components of clock alignment circuit 110. An integrated circuit chip may include clock alignment circuit 110. Those skilled in the art will appreciate there may be additional components in clock alignment circuit 110.

Comparator comp211 is an electronic circuit that compares two input voltages and outputs a binary signal indicating which input is higher. Comparator comp211 may include a non-inverting input terminal (+), an inverting input terminal (-), and a single output. Illustrated in the example of FIG. 2, the non-inverting input terminal (+) is directly connected to the feedback line 211, while the inverting input terminal (-) is directly connected to the midpoint voltage line 122. Comparator comp211 is circuitry that may compare the feedback voltage on the feedback line 211 with the midpoint voltage on the midpoint voltage line 122. Based on this comparison, comparator comp211 may generate a control voltage V(cp) on the output line 211. The voltage level of the control voltage V(cp) indicates whether the feedback voltage on the feedback line 211 is higher or lower than the midpoint voltage.

Comparator comp212 is an electronic circuit that compares two input voltages and outputs a binary signal indicating which input is higher. Comparator comp212 may include a non-inverting input terminal (+), an inverting input terminal (-), and a single output. Illustrated in the example of FIG. 2, the non-inverting input terminal (+) is directly connected to the midpoint voltage line 122, while the inverting input terminal (-) is directly connected to the feedback line 212. Comparator comp212 is circuitry that may compare the feedback voltage on the feedback line 212 with the midpoint voltage on the midpoint voltage line 122. Based on this comparison, comparator comp212 may generate a control voltage V(cn) on the output line 212. The voltage level of the control voltage V(cn) indicates whether the feedback voltage on the feedback line 212 is higher or lower than the midpoint voltage.

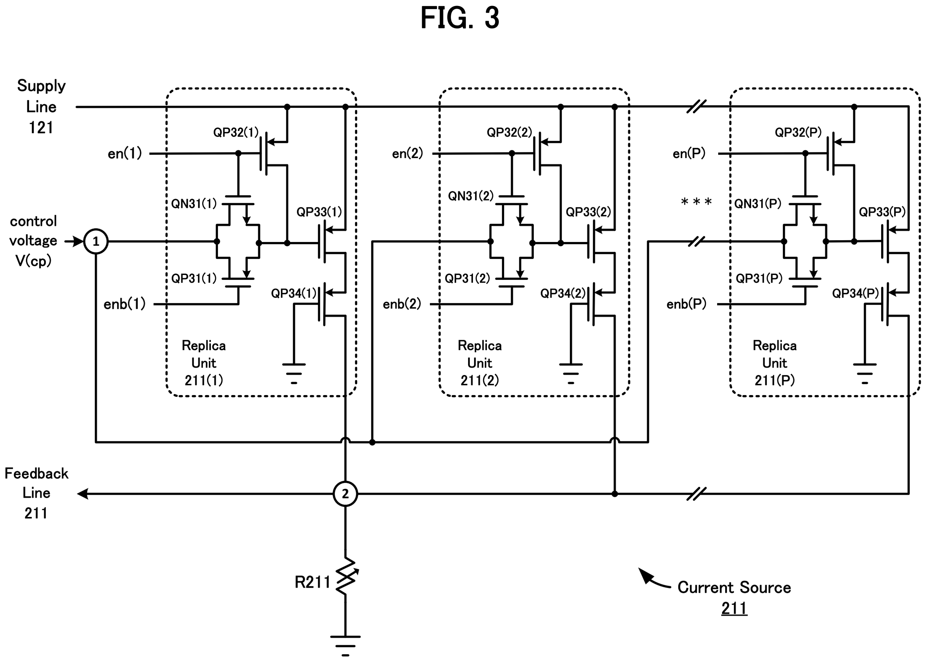

FIG. 3 illustrates example current source 211. Current source 211 is a variable current source that may include replica units 211(1)-211(P) with "P" being an integer greater than 1. Each of the replica units 211(1)-211(P) may include N-type transistor QN31 and P-type transistors QP31, QP32, QP33 and QP34. A plurality of replica units 211(1)-211(P) is collectively referred to as "replica units 211." Any one of the replica units 211(1)-211(P) is individually referred to as "replica unit 211." Replica unit 211 may include transistors QN31, QP31 in the form of a transmission gate. Transmission gate QN31, QP31 may include N-type transistor QN31 in parallel with P-type transistor QP31 with the sources and drains of transistors QN31, QP31 being connected together. Those skilled in the art will appreciate there may be additional components in a replica unit 211.

Current source 211 and current sink 212 may receive enable signals en(1)-en(P) and enable signals enb(1)-enb(P) from control circuitry 216. Enable signal en(i) may be one of the enable signals en(1)-en(P). Similarly, enable signal enb(i) may be one of the enable signals enb(1)-en(P). Enable signal en(i), enb(I) are complementary signals (enable signal enb = NOT enable signal en). Referred to herein, complementary signals are a pair of signals where one signal is the logical opposite of the other, ensuring that when one signal is logic high at the same time that the other is logic low. Enable signal en(i) at logic high along with enb(i) being logic low is referred to herein as a "activating state." Enable signal en(i) at logic low along with enb(i) being logic high is referred to herein as a "deactivating state." A complementary pair of enable signals en(i), enb(i) is referred to as an "enable signal."

An enable signal may toggle replica unit 211 between an operational state and an inactive state. The enable signal in the deactivating state may cause replica unit 211 to enter into the inactive state. For example, in replica unit 211, enable signal en(i) is applied to the gates of transistors QN31, QP32 along with enable signal enb(i) being applied to the gate of transistor QP31. The enable signal in the deactivating state may cause transmission gate QN31, QP31 to become non-conductive thereby placing the path from wiring node 1 to the output of transistors QN31, QP31 in a high impedance state. Also while in the deactivating state, the enable signal may cause transistor QP32 to become conductive and electrically connect the source of transistor QP33 directly to the gate of transistor QP33 so as to pull the gate of transistor QP33 to the supply voltage (Vdd). Pulling the gate of transistor QP33 to the supply voltage (Vdd) may cause transistor QP33 to become non-conductive, along with an absence of current flow between the source and drain of transistor QP33. In the inactive state, replica unit 211 is electrically isolated from other parts of the clock alignment circuit 110. While electrically isolated from other parts of the clock alignment circuit 110, the replica unit 211 ceases drawing the control voltage from the output line, ceases receiving the control voltage V(cp) from node 1, and ceases providing a current flow to node 2.

Conversely, the enable signal in the activating state may cause replica unit 211 to enter into the operational state. For example, enable signal en(i) at logic high along with enb(i) being logic low may cause transmission gate QN31, QP31 to become conductive and allow a control voltage V(cp) at node 1 to drive transistor QN33. Enable signal en(i) at logic high may also cause transistor QP32 to become non-conductive so as to permit a flow of current between the source and drain of transistor QP33. In the example of FIG. 3, the gate of transistor QN34(i) is electrically connected directly to ground. While in the operational state, replica unit 211 is electrically connected to other parts of the clock alignment circuit 110 receiving control voltage V(cp) from node 1 and drawing current from supply line 121 to node 2.

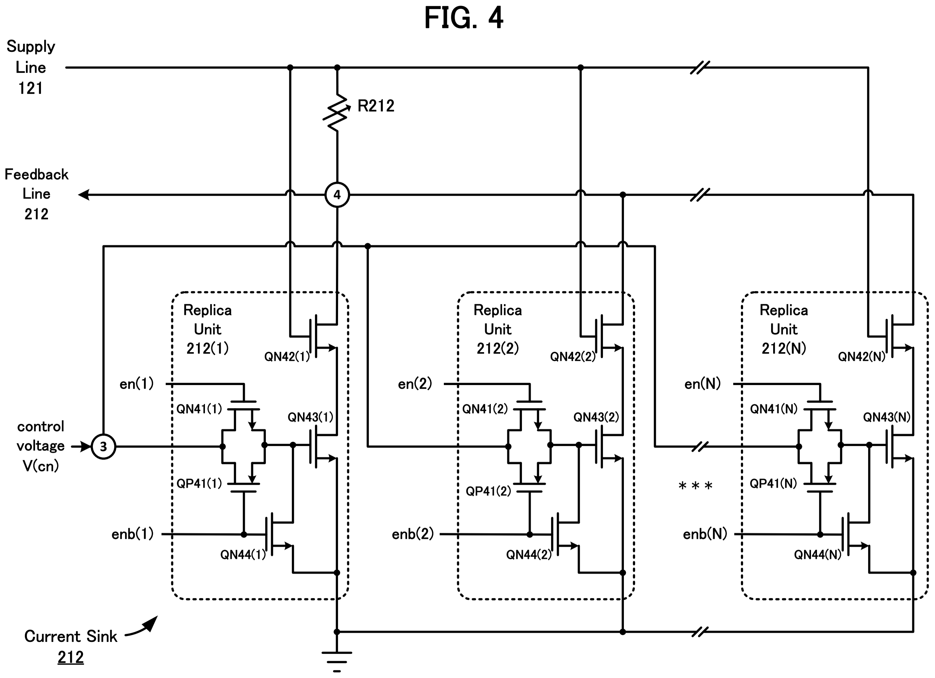

FIG. 4 illustrates example current sink 212. Current sink 212 is a variable current sink that may include replica units 212(1)-212(N) with "N" being an integer greater than 1. Each of the replica units 212(1)-212(N) may include P-type transistor QP41 and N-type transistors QN41, QN42, QN43 and QN44. A plurality of replica units 212(1)-212(N) is collectively referred to as "replica units 212." Any one of the replica units 212(1)-212(N) is individually referred to as "replica unit 212." Replica unit 212 may include transistors QP41, QN41 in the form of a transmission gate. Transmission gate QP41, QN41 may include P-type transistor QP41 in parallel with N-type transistor QN41 with the sources and drains of transistors QP41, QN41 being connected together. Those skilled in the art will appreciate there may be additional components in a replica unit 212.

An enable signal may toggle replica unit 212 between an operational state and an inactive state. The enable signal in the deactivating state may cause replica unit 212 to enter into the inactive state. For example, in replica unit 212, enable signal en(i) is applied to the gates of transistors QN41, QN44 along with enable signal enb(i) being applied to the gate of transistor QP41. The enable signal in the deactivating state may cause transmission gate QP41, QN41 to become non-conductive thereby placing the path from wiring node 3 to the output of transistors QP41, QN41 in a high impedance state. Also while in the deactivating state, the enable signal may cause transistor QN44 to become conductive and electrically connect the source of transistor QN43 directly to the gate of transistor QN43 so as to pull the gate of transistor QN43 to ground. Pulling the gate of transistor QN43 to ground may cause transistor QN43 to become non-conductive, along with an absence of current flow between the source and drain of transistor QN43. While in the inactive state, replica unit 212 is electrically isolated from other parts of the clock alignment circuit 110 receiving no current flow to node 4, receiving no control voltage V(cn) from node 3, and sinking no current to ground.

Conversely, the enable signal in the activating state may cause replica unit 212 to enter into the operational state. For example, enable signal en(i) at logic high along with enb(i) being logic low may cause transmission gate QP41, QN41 to become conductive and allow a control voltage V(cn) at node 3 to drive transistor QP43. Enable signal enb(i) at logic low may also cause transistor QN44 to become non-conductive so as to permit a flow of current between the source and drain of transistor QN43. In the example of FIG. 4, the gate of transistor QP42 is electrically connected directly to supply line 121. While in the operational state, replica unit 212 is electrically connected to other parts of the clock alignment circuit 110 receiving control voltage V(cn) from node 3 and drawing current from node 4 to ground.

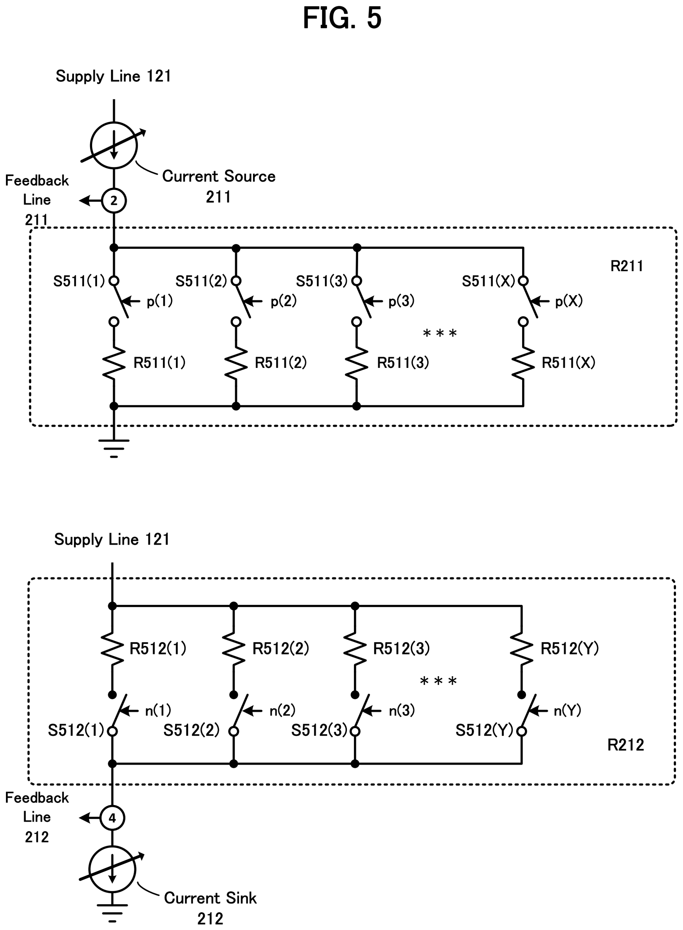

FIG. 5 illustrates exemplary configurations for resistance circuits R211, R212. Resistance circuits R211, R212 may each be a circuit whose resistive value is electronically adjustable. Referred to herein, a resistive value is the numerical representation of the electrical resistance (measured in ohms) for each of the resistance circuits R211, R212.

Resistance circuit R211 is circuit that may include switches S511(1)-(X) and resistors R511(1)-(X). Resistance circuit R212 is circuit that may include switches S511(1)-(X) and resistors R511(1)-(X) with "X" being an integer greater than 1. Any one of the resistors R511(1) - R511(X) could be individually referred to as "resistor R511." Any one of the switches S511(1) - S511(X) could be individually referred to as "switch S511." Switch S511(1) corresponds with resistor R511(1), switch S511(2) corresponds with resistor R511(2), switch S511(3) corresponds with resistor R511(3), and switch S511(X) corresponds with resistor R511(X) by way of illustration. In some configurations, a resistance for one of the resistors R511(1) - R511(X) may differ from a resistance for another of the resistors R511(1) - R511(X). In other configurations, each of the resistors R511(1) - R511(X) could be of the same resistance.

Control signals p(1)-p(X) from control circuitry 216 may manage the conductive and non-conductive states of switches S511(1) - S511(X). For instance, control signals p(1)-p(X) may independently cause the opening and closure of switches S511(1) - S511(X). Being independently controllable, switches S511(1) - S511(X) may operate individually of one another. In response to the opening of a switch S511, the switch S511 will become non-conductive and inhibit the passage of current from wiring node 2 to ground through a corresponding resistor R511. Two or more of the switches S511(1) - S511(X) may become simultaneously conductive in some instances. However, at least one of the switches S511(1) - S511(X) is conductive during each instance. The opening and closure of switches S511(1) - S511(X) may adjust the resistive value of variable resistance R511.

Resistance circuit R512 may include resistors R512(1) - R512(Y) and switches S512(1) - S512(Y) with "Y" being an integer greater than 1. "Y" could be an integer value differing from "X" in some implementations. In other implementations, "X" and "Y" may both be the same integer value. Any one of the resistors R512(1) - R512(Y) could be individually referred to as "resistor R512." Any one of the switches S512(1) - S512(Y) could be individually referred to as "switch S512." In some configurations, a resistance for one of the resistors R512(1) - R512(Y) may differ from a resistance for another of the resistors R512(1) - R512(Y). In other configurations, each of the resistors R512(1) - R512(Y) could be of the same resistance.

Control signals n(1)-n(Y) from control circuitry 216 may independently manage the conductive and non-conductive states of switches S512(1) - S512(Y). Being independently controllable, switches S512(1) - S512(Y) may operate individually of one another. Control signals n(1)-n(Y) may cause the opening and closure of switches S512(1) - S512(Y). In response to the closure of a switch S512, the switch S512 will become conductive and cause the passage of the supply voltage line 121 through a corresponding resistor R512 to wiring node 4. In FIG. 5, switch S512(1) corresponds with resistor R512(1), switch S512(2) corresponds with resistor R512(2), and switch S512(Y) corresponds with resistor R512(Y) by way of illustration. In response to the opening of a switch S512, the switch S512 will become non-conductive and inhibit the passage of current to wiring node 4 through corresponding resistor R512. Two or more of the switches S512(1) - S512(Y) may become simultaneously conductive in some situations, at least one of the switches S512(1) - S512(Y) is conductive during each of the situations. The opening and closure of switches S512(1) - S512(Y) may adjust the resistive value of resistance circuit R512.

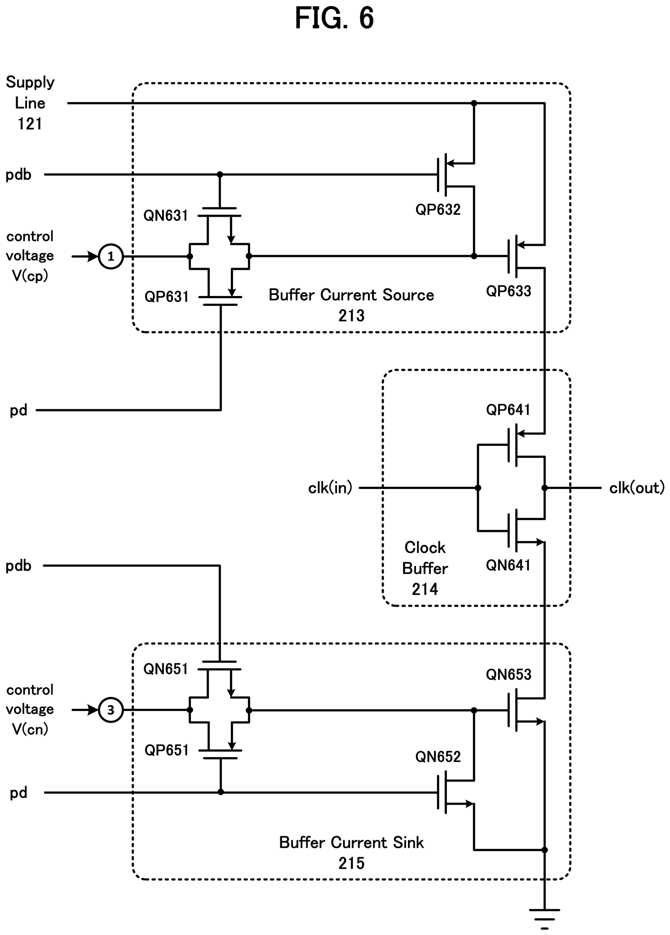

Referring to FIG. 6, illustrated are buffer current source 213, clock buffer 214 and buffer current sink 215. Buffer current source 213 and buffer current sink 215 may receive selection signals pd, pdb from control circuitry 216. Selection signals pd, pdb are complementary signals so that at any given time, one of the selection signals pd, pdb is logic high while the other of the selection signals pd, pdb is logic low. Selection signals pd, pdb may independently activate and deactivate buffer current source 213 and buffer current sink 215.

By way of illustration, buffer current source 213 may include transistors QN631, QP631, in the form of a transmission gate. A transmission gate may include N-type transistor QN631 in parallel with P-type transistor QP631 with the sources and drains of transistors QN631, QP631 being connected together. Selection signal pd is applied to the gate of transistor QP631. Selection signal pdb is applied to the gate of transistor QN631.

Being that selection signals pd, pdb are complementary signals, selection signal pd at logic low along with selection signal pdb being logic high may cause transmission gate QP631, QN631 to become conductive and allow a control voltage V(cp) on output line 211 to drive transistor QP633. Selection signal pdb being logic high may also cause transistor QP632 to become non-conductive so as to permit a flow of current between the source and drain of transistor QP633.

Conversely, selection signal pd at logic high along with selection signal pdb being logic low may cause transmission gate QP631, QN631 to become non-conductive thereby placing the path from wiring node 1 to the output of transistors QP631, QN631 in a high impedance state. Selection signal pdb at logic low may also cause transistor QP632 to become conductive and electrically connect the gate of transistor QP633 directly to the source of transistor QP633 so as to pull the gate of transistor QP633 to the supply voltage (Vdd). Pulling the gate of transistor QP633 to the supply voltage (Vdd) may cause transistor QP633 to become non-conductive, along with an absence of current flow between the source and drain of transistor QP633.

Clock buffer 214 may include CMOS transistors QN641, QP641.

Buffer current sink 215 may include transistors QN651, QP651, in the form of a transmission gate. A transmission gate may include N-type transistor QN651 in parallel with P-type transistor QP651 with the sources and drains of transistors QN651, QP651 being connected together. Selection signal pd is applied to the gate of transistor QP651. Selection signal pdb is applied to the gate of transistor QN651.

Being that selection signals pd, pdb are complementary signals, selection signal pd at logic low along with selection signal pdb being logic high may cause transmission gate QN651, QP651 to become conductive and allow a control voltage V(cn) on output line 212 to drive transistor QN653. Selection signal pd being logic low may also cause transistor QN652 to become non-conductive so as to permit a flow of current between the source and drain of transistor QN653.

Conversely, selection signal pd at logic high along with selection signal pdb being logic low may cause transmission gate QN651, QP651 to become non-conductive thereby placing the path from wiring node 3 to the output of transistors QN651, QP651 in a high impedance state. Selection signal pd at logic high may also cause transistor QN652 to become conductive and electrically connect the gate of transistor QN653 directly to the source of transistor QN653 so as to pull the gate of transistor QN653 to ground. Pulling the gate of transistor QN653 to ground may cause transistor QN653 to become non-conductive, along with an absence of current flow between the source and drain of transistor QN653.

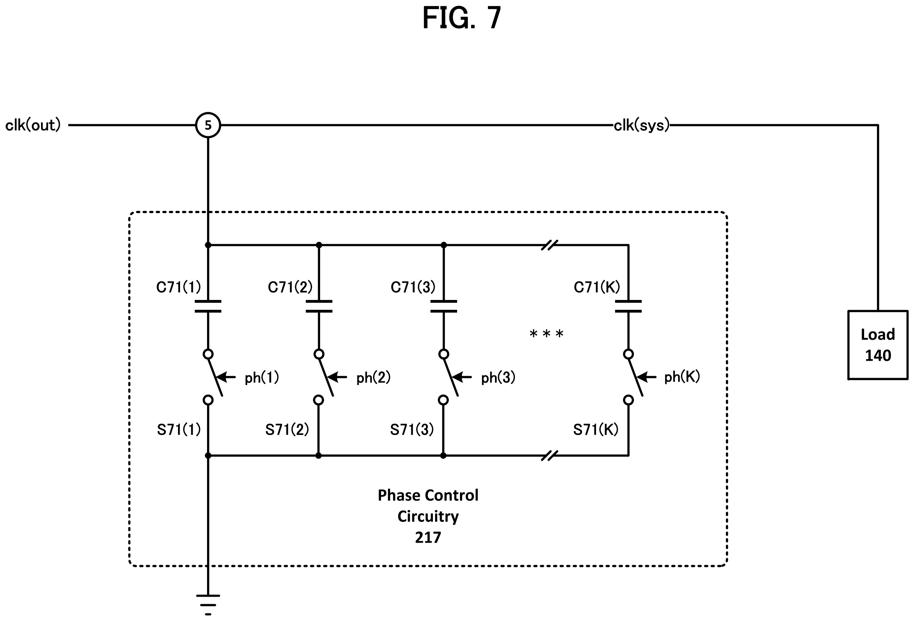

Turning now to FIG. 7, phase control circuitry 217 may include capacitors C71(1) - C71(K) and switches S71(1) - S71(K) with "K" being an integer greater than 1. In some implementations, phase control circuitry 217 may be a Metal-Oxide-Metal (MOM) capacitor bank. A MOM capacitor bank is an array of MOM capacitors that can be selectively connected or disconnected to achieve a desired total capacitance. In some configurations, a capacitance for one of the capacitors C71(1) - C71(K) may differ from a capacitance for another of the capacitors C71(1) - C71(K). In other configurations, each of the capacitors C71(1) - C71(K) could be of the same capacitance. Phase signals ph(1)-ph(K) from control circuitry 216 may independently manage the conductive and non-conductive states of switches S71(1) - S71(K). Being independently controllable, switches S71(1) - S71(K) may operate individually of one another.

Any one of the capacitors C71(1) - C71(K) could be individually referred to as "capacitor C71." Any one of the switches S71(1) - S71(K) could be individually referred to as "switch S71." Switch S71 is in series with capacitor C71. Phase signals ph(1)-ph(K) from control circuitry 216 may cause the opening and closure of switches S71(1) - S71(K). In response to the closure of switch S71, switch S71 will become conductive and cause the passage of current between wiring node 5 and ground through a corresponding capacitor C71. Switch S71(1) corresponds with capacitor C71(1), switch S71(2) corresponds with capacitor C71(2), switch S71(3) corresponds with capacitor C71(3), and switch S71(K) corresponds with capacitor C71(K) in FIG. 7 by way of illustration. In response to the opening of a switch S71, switch S71 will become non-conductive and inhibit the passage of current between wiring node 5 and ground through corresponding capacitor C71. More of the switches S71(1) - S71(K) may be opened to achieve greater delay in system clk(sys). Closure of the switches S71(1) - S71(K) may reduce the delay in system clk(sys). Although two or more of the switches S71(1) - S71(K) may become simultaneously conductive in some situations, at least one of the switches S71(1) - S71(K) is conductive during each of the situations.

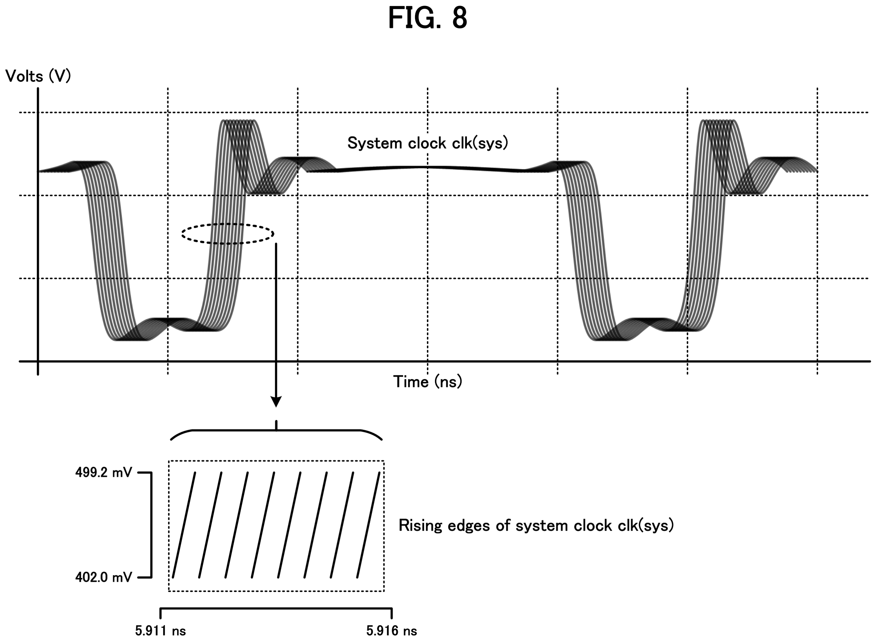

Illustrated in FIG. 8, clock alignment circuit 110 may produce system clk(sys) having sharp clock rise and fall times. For instance, clock alignment circuit 110 may system clk(sys) having a linear step size with a negligible change in range, rise/fall time, step size, and jitter after 10-years stressed aging simulations.

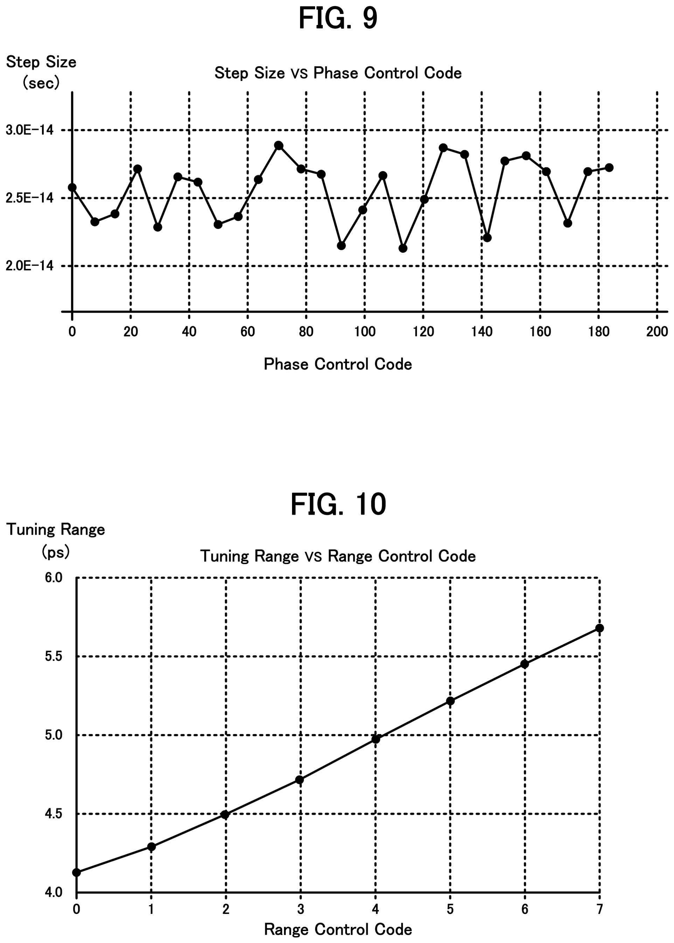

Laboratory measurements in FIG. 9 depict very stable and fine step sizes (<30fs) across a range (0-191 steps) after aging and for variances in process, voltage, and temperature.

Illustrated in FIG. 10, eight different settings provide a -12% ~ +20.0% range for the clock mismatch adjustment among sixteen lanes.

Those skilled in the art will also appreciate the arrangement or interconnection of components such as "coupled," "connected," "on," "under," or similar wording allows for indirect connections, or intervening components or layers.

Certain operations of methods according to the technology, or of systems executing those methods, may be represented schematically in the figures or otherwise discussed herein. Unless otherwise specified or limited, representation in the figures of particular operations in particular spatial order may not necessarily require those operations to be executed in a particular sequence corresponding to the particular spatial order. Correspondingly, certain operations represented in the figures, or otherwise disclosed herein, may be executed in different orders than are expressly illustrated or described, as appropriate for particular examples of the technology. Further, in some examples, certain operations may be executed in parallel or partially in parallel, including by dedicated parallel processing devices, or separate computing devices configured to interoperate as part of a large system.

As used herein, unless otherwise limited or defined, "or" indicates a non-exclusive list of components or operations that may be present in any variety of combinations, rather than an exclusive list of components that may be present only as alternatives to each other. For example, a list of "A, B, or C" indicates options of: A; B; C; A and B; A and C; B and C; and A, B, and C.

Correspondingly, the term "or" as used herein is intended to indicate exclusive alternatives only when preceded by terms of exclusivity, such as, e.g., "either," "only one of," or "exactly one of." Further, a list preceded by "one or more" (and variations thereon) and including "or" to separate listed elements indicates options of one or more of any or all of the listed elements.

For example, the phrases "one or more of A, B, or C" and "at least one of A, B, or C" indicate options of: one or more A; one or more B; one or more C; one or more A and one or more B; one or more B and one or more C; one or more A and one or more C; and one or more of each of A, B, and C.

Similarly, a list preceded by "a plurality of" (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

In general, the term "or" as used herein only indicates exclusive alternatives (e.g., "one or the other but not both") when preceded by terms of exclusivity, such as, e.g., "either," "only one of," or "exactly one of."

Any mark, if referenced herein, may be common law or registered trademarks of third parties affiliated or unaffiliated with the applicant or the assignee. Use of these marks is by way of example and shall not be construed as descriptive or to limit the scope of disclosed or claimed embodiments to material associated only with such marks.

The articles "a," "an," and "the" are intended to include the plural forms as well, unless the context clearly indicates otherwise.

The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

Throughout the application, ordinal numbers (e.g., first, second, third and so forth.) may be used as an adjective for an element (i.e., any noun in the application).

Although terms such as "first," "second," and "third" may be used herein to describe various members, components, regions, layers, or sections, these members, components, regions, layers, or sections are not to be limited by these terms.

Rather, these terms are only used to distinguish one member, component, region, layer, or section from another member, component, region, layer, or section.

The use of ordinal numbers is not to imply or create any particular ordering of the elements nor to limit any element to being only a single element unless expressly disclosed, such as by the use of the terms "before," "after," "single," and other such terminology.

Rather, the use of ordinal numbers is to distinguish between the elements.

By way of an example, a first element is distinct from a second element, and the first element may encompass more than one element and succeed (or precede) the second element in an ordering of elements.

Thus, a first member, component, region, layer, or section referred to in examples described herein may also be referred to as a second member, component, region, layer, or section without departing from the teachings of the examples.

## Claims

1. An apparatus comprising:
a comparator configured to output, onto an output line upon comparing a midpoint voltage with a feedback voltage, a control voltage indicating whether the feedback voltage is higher or lower than the midpoint voltage; and
a plurality of replica current sources each configured to draw a supply voltage from a supply line and the control voltage from the output line, a replica current source being one of the replica current sources,
wherein, in response to an enable signal being in a deactivating state, the replica current source is configured to enter into an inactive state, and
wherein, in response to the replica current source entering into the inactive state, the replica current source is configured to cease drawing the control voltage from the output line.

2. The apparatus according to claim 1, further comprising:
a current source resistance circuit electrically connected between the replica current sources and ground, a resistive value of the current source resistance circuit being adjustable in response to a control signal.

3. The apparatus according to claim 1 or 2, wherein
each of the replica current sources being identical to one another.

4. The apparatus according to any one of the claims 1 to 3, wherein
the replica current source is configured to convert, upon drawing the supply voltage from the supply line, the supply voltage into the feedback voltage.

5. The apparatus according to claim 4, wherein
in response to the control voltage indicating that the feedback voltage is less than the midpoint voltage, the replica current source is configured to refrain from drawing the supply voltage from the supply line.

6. The apparatus according to any one of the claims 1 to 5, wherein
in response to the enable signal being in the deactivating state, the replica current source is configured to refrain from drawing the supply voltage from the supply line.

7. The apparatus according to any one of the claims 1 to 6, wherein
the replica current source is configured to permit, in response to the enable signal being in an activating state, the replica current source to draw the supply voltage from the supply line;
wherein in particular
the replica current source is configured to permit, in response to the enable signal being in the activating state, the replica current source to draw the control voltage.

8. The apparatus according to any one of the claims 1 to 7, further comprising:
a buffer current source configured to convert, upon drawing the supply voltage from the supply line, the supply voltage into a buffer current.

9. The apparatus according to claim 8, further comprising:
a clock buffer configured to output, upon applying the control voltage so as to condition an input clock, the input clock in the form of a buffered clock.

10. The apparatus according to claim 9, further comprising:
a phase control circuitry configured to output, in response to adjusting a phase of the buffered clock, the buffered clock in the form of a system clock; wherein in particular
the phase control circuitry is electrically connected between ground and an output from the clock buffer, a capacitance value of the phase control circuitry being adjustable in response to a phase signal.

11. The apparatus according to any one of the claims 8 to 10, further comprising:
a buffer current sink configured to cause, in response to a selection signal being in the deactivating state, the buffer current sink to enter into the inactive state.

12. The apparatus according to claim 11, wherein
the buffer current sink is configured to refrain, upon entering into the inactive state, from drawing the buffer current to ground;
and/or wherein
the buffer current sink configured to permit, in response to the selection signal being in an activating state, the buffer current sink to draw the buffer current to ground.

13. The apparatus according to claim 11 or 12, wherein
the buffer current sink configured to refrain, in response to an additional control voltage indicating that a current level of an additional feedback voltage is greater than the supply voltage, from drawing the buffer current to ground.

14. The apparatus according to claim 13, further comprising:
a plurality of replica current sinks each configured to draw current from a current sink resistance circuit to ground, a resistive value of the current sink resistance circuit being adjustable;
wherein in particular
a replica current sink is one of the replica current sinks, and
the replica current sink is configured to cause, in response to the enable signal being in the deactivating state, the replica current sink to enter into the inactive state;
wherein further in particular
the replica current sink is configured to refrain, upon entering into the inactive state, from drawing the control voltage from the output line.

15. A method comprising:
outputting, onto an output line upon comparing a midpoint voltage with a feedback voltage, a control voltage indicating a higher or lower current level;
entering, in response to an enable signal being in a deactivating state, a replica current source into an inactive state; and
ceasing, upon entering into the inactive state, drawing the control voltage from the output line.
